# EUROPEAN PATENT APPLICATION

(11) **EP 4 797 320 A1**
(43) Date of publication of application: **26.08.2026**
(21) Application number: 25159219.2
(22) Date of filing: 20.02.2025
(51) Int. Cl.: H01L 21/3065, H01L 21/033

(54) **A METHOD FOR PRODUCING ELONGATE PATTERN FEATURES BY APPLYING DIRECTIONAL ETCHING**

(71) Applicant: Imec VZW, 3001 Leuven (BE)
(72) Inventor: Lazzarino, Frederic, 1320 Hamme-Mille (BE)
(74) Representative: Patent Department IMEC

(57) **Abstract**

A layer (28) is produced on an etch stop layer (27) formed on a support substrate. The layer is patterned by forming at least one opening (30) having upright sidewalls through the full thickness of the layer. The opening is enlarged by a sequence of directional etch steps wherein the angle of incidence of the applied plasma beam (8) is increased at every subsequent step compared to the previous step, so that the plasma beam impinges on the full height of the sidewall of the opening (30) or enlarged opening (31) at every step. Subsequent directional etch steps can be performed in the same scanning direction at each step, or the scanning direction can be changed at every step or combinations of equal and differing scanning directions can be applied, enabling thereby to obtain various shapes of pattern features. The adjustment of the angle of incidence enables a higher etch rate in the scanning direction and thereby a higher obtainable elongation compared to methods wherein repeated directional etch steps are performed applying he same angle of incidence at each step.

## Description

### Field of the Invention

The present invention is related to semiconductor fabrication processes, in particular to patterning methods applicable for realizing nanometre-sized features in a patterned layer.

### State of the art.

Semiconductor fabrication processing relies on advanced lithography and etch technologies capable of realizing patterns at the nanometre-sized scale required in the front-end-of-line and at the deepest levels of the back-end-of-line process sequences. Nevertheless, even the most advanced EUV lithography tools are limited in terms of the obtainable resolution, requiring expensive multiple exposure methods for printing features smaller than the resolution limit.

Directional patterning techniques represent one interesting way of overcoming these limitations. The term 'directional patterning' encompasses directional etching and directional deposition.

Basic principles and configurations for realizing directional patterning are for example described in patent publication document US10790155. According to the technology, a plasma beam is scanned relative to a substrate comprising a layer that is to be patterned. By tuning several parameters and conditions, it is possible to direct a plasma beam containing etch species so that the beam etches a layer on the wafer at a considerably higher etch rate in the scanning direction than in directions orthogonal to said scanning direction. This capability makes it possible to 'stretch' an existing opening in the layer by scanning a plasma beam across the opening.

Directional etching thereby enables patterning line features at sub-resolution pitch. Starting from a pattern of openings obtainable by anisotropic etching and taking advantage of a judicious arrangement of the openings, the openings are stretched so as to obtain lines at the required sub-resolution pitch. This approach is also described in US10790155.

One problem related to directional etching is that the etch rate in the direction perpendicular to the support substrate is not zero and causes thinning of the layer patterned by the directional etching process. This aspect limits the obtainable elongation and makes it difficult to obtain line features above a given length.

### Summary of the invention

The invention is related to a method in accordance with the appended claims. A layer is produced on an etch stop layer formed on a support substrate. The layer is patterned by forming at least one opening having upright sidewalls through the full thickness of the layer. The opening is enlarged by a sequence of directional etch steps wherein the angle of incidence of the applied plasma beam is increased at every subsequent step compared to the previous step, so that the plasma beam impinges on the full height of the sidewall of the opening or enlarged opening at every step. Subsequent directional etch steps can be performed in the same scanning direction at each step, or the scanning direction can be changed at every step or combinations of equal and differing scanning directions can be applied, enabling thereby to obtain various shapes of pattern features.

The adjustment of the angle of incidence enables a higher etch rate in the scanning direction and thereby a higher obtainable elongation compared to methods wherein repeated directional etch steps are performed applying the same angle of incidence at each step.
The invention is in particular related to a patterning method applicable in a semiconductor production process, comprising the steps of :
- producing an etch stop layer on a support substrate,
- producing a layer on the etch stop layer,
- patterning said layer thereby obtaining a patterned layer comprising at least one opening having upright sidewalls and extending through the full thickness of the patterned layer,
- in the patterned layer, elongating the at least one opening by directional etching selectively relative to the etch stop layer, wherein said directional etching is performed according to a sequence of consecutive directional etching steps under the influence of a plasma beam oriented according to an angle of incidence relative to the plane of the patterned layer and scanned in a scanning direction relative to the opening, and wherein :
   ∘ the patterned layer is thinned progressively under the influence of the consecutive directional etch steps,
   ∘ in each step, an angle of incidence is applied that enables the beam to impinge on the full height of a sidewall of the opening at the start of the step,
   ∘ in each subsequent step, the angle of incidence is increased compared to the angle applied in the step immediately preceding said subsequent step,
   ∘ the sequence continues until a predefined elongation of the opening is obtained.
According to an embodiment, the scanning direction is changed at every subsequent step compared to the scanning direction applied in the step preceding said subsequent step.

According to an embodiment, the scanning direction of each subsequent step is diametrically opposed to the scanning direction of the preceding step, so that the pattern of geometrical features is a pattern of parallel lines.

According to an embodiment, the scanning direction of one or more subsequent directional etch steps is perpendicular to the scanning direction of the preceding step.

According to an embodiment, the patterned layer is patterned according to a pattern comprising a regular array of said openings through the full thickness of the patterned layer, the array comprising rows of aligned openings, wherein the directional etch steps are performed in scanning directions aligned to said rows, until the enlarged openings merge into a set of parallel lines.

According to an embodiment, an etch stop layer is produced on a target layer present on the support substrate, wherein the layer produced in the etch stop layer is a mask layer, and wherein the mask layer is patterned according to any one of the preceding claims, followed by transferring the pattern finally obtained in the mask layer to the target layer.

According to an embodiment, the mask layer comprises a stack of sublayers, comprising from bottom to top :
- a first hardmask layer of a thickness t1,
- a second hardmask layer of a thickness higher than t1,
- a third hardmask layer of a thickness essentially equal to t1.
and wherein the third hardmask layer is consumed during the patterning of the mask layer to form said at least one opening having upright sidewalls through the first and second hardmask layers.

### Brief description of the figures

Figure 1 illustrates the main components of a tool suitable for directional etching.
Figures 2a to 2c illustrate the process of directional etching.
Figures 3a and 3b illustrate the shadow effect and how this can have a negative impact on a directional etching process.
Figures 4 to 12 illustrate a process sequence in accordance with an embodiment of the invention.
Figures 13 to 15 illustrate pattern features obtainable by alternative sequences of directional etching steps in accordance with embodiments of the invention.

### Detailed description of the invention

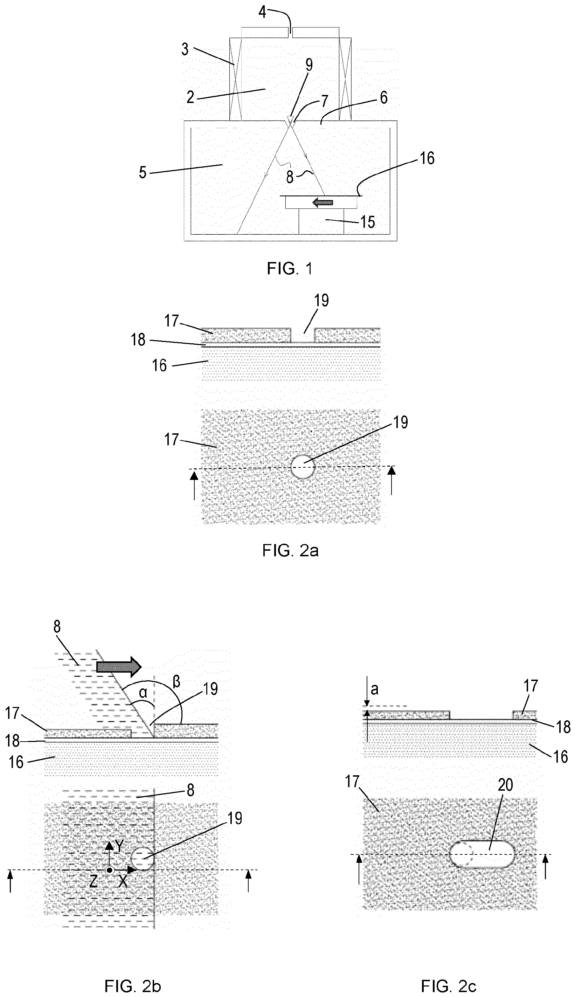

Figure 1 illustrates a process tool 1 for applying one particular directional etching technology that is presently known in the state of the art. The invention is however not limited to this technology. The tool comprises a plasma chamber 2 surrounded by an RF coil 3 for generating a plasma in the chamber. A gas inlet 4 enables supplying a gaseous substance, while the overall pressure in the plasma chamber is kept at very low to vacuum level by a suitable vacuum pump installation (not shown). The plasma chamber 2 is separated from a process chamber 5 by a separating wall 6 comprising a slit 7, so that ribbon plasma beams 8 are emitted from the slit. The process chamber is also at low to vacuum pressure. A meniscus 9 may be mounted in the vicinity of the slit 7 at a distance that can be set in order to control the propagation direction of the emitted beams 8. A wafer stage 15 is mounted in the process chamber 5. The wafer stage 15 is movable linearly as indicated by the arrow, so that a wafer 16 held by the wafer stage can be moved relative to one of the beams 8, thereby creating the equivalent of the beam 8 being scanned across the wafer 16.

As stated, other directional etching technologies are known and can be applied in the method according to the invention. Ion beam-based technologies include a method wherein a collimated beam of charged particles e.g. Ar⁺ is accelerated on a full wafer at a given angle of incidence. In the latter method, the wafer stage is not moving relative to the beam as the beam is impinging on the full wafer. According to another known ion beam-based technology, a collimated beam of ionized gas clusters is accelerated to a spot and scanned across a wafer surface at a given angle of incidence. In the latter two technologies, the angle of incidence of the beam may be adjusted by tilting the wafer.

Figures 2a to 2c illustrate the directional etching effect on a layer 17 formed on the wafer 16. The layer 17 is produced on an etch stop layer 18. Before applying the directional etch process, an opening 19 is formed in the layer 17 by standard lithography and etching, for example by direct ion etching (DIE). With reference to Figure 2b, a plasma beam 8 is generated and directed at an angle of incidence α, defined as the angle between the beam 8 and the direction perpendicular to the surface of the layer 17. By moving the wafer stage 15 in the direction indicated in Figure 1, the plasma beam 8 is scanned relative to the layer 17 in a scanning direction +X. The angle β between the beam 8 and the scanning direction X is an oblique angle equal to 90°+α. By applying a suitable combination of etch parameters such as the RF power, a DC bias voltage connected to the separator plate 6 and/or the wafer stage 15, the applied etch species, the angle of incidence α and the scanning speed, scanning the beam across the opening 19 has the effect of stretching the opening in the scanning direction, as illustrated in Figure 2c. The directional etch process is selective with respect to the etch stop layer 18 so that this layer remains essentially intact and prohibits etching of the underlying support substrate 16. The etch rate in the X-direction is considerably higher than the etch rate in the Y and Z-directions. The result is therefore an elongation of the opening 19 in the X-direction to form a line-shaped trench 20. In the Y-direction the line is slightly larger than the original diameter of the opening 19, due to the non-zero etch rate in the Y direction. Etching in the Z-direction causes thinning of the layer 17 by a layer thickness reduction a.

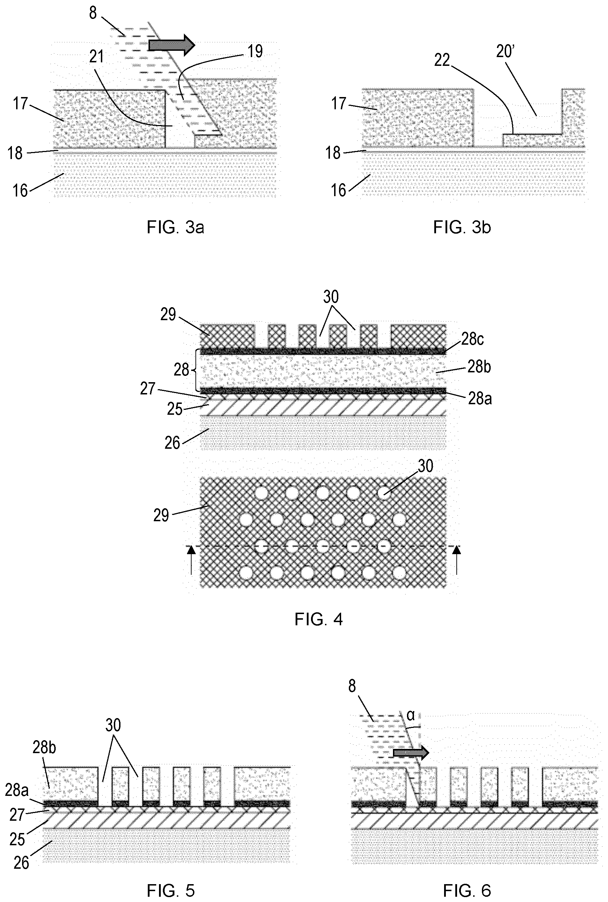

When the initial opening 19 is deeper however, the beam may not be able to perform the directional etch process completely, as illustrated in Figures 3a and 3b. This is due to the so-called shadow-effect : as shown in Figure 3a, the upstream side of the opening 19 creates a shadow area 21 where the beam cannot propagate. As the beam progresses in the scanning direction X, this shadow effect prohibits the beam from impinging on the full height of the sidewall of the elongated trench 20' so that a step 22 remains at the bottom of said trench..

This problem can be remedied by reducing the angle of incidence of the beam, i.e. orienting the beam closer to the direction perpendicular to the layer that is being patterned by directional etching. This will however also increase the etch rate in the Z-direction, so that the layer is thinned faster. At the same time, the smaller angle of incidence will decrease the etch rate in the X-direction, i.e. the elongation takes place slower. These effects make it difficult to create significant elongations starting from any given initial diameter of the openings.

Figures 4 to 12 illustrate a process sequence in accordance with an embodiment of the invention. The embodiment is related to the elongation of openings arranged initially in a regular pattern of openings, but the invention is not limited thereto, and is applicable to any regular or irregular pattern of one or more openings.

In the illustrated embodiment, the aim is to pattern a target layer 25 formed on a support substrate 26. The target layer 25 may be any layer that needs to be patterned in the course of a semiconductor fabrication process, for example a dielectric layer formed in the course of the back end of line fabrication of integrated circuits produced on a silicon process wafer, wherein the dielectric layer needs to be patterned by creating parallel line-shaped trenches at a regular pitch, to be filled thereafter with metal to form conductive paths. The invention is however not limited to any type of layer that is to be patterned, nor to any particular stage within a semiconductor fabrication process.

With reference to Figure 4 : on top of the target layer 25, a stack of several layers is produced. In direct contact with the target layer 25, an etch stop layer 27 is formed, followed by a mask layer 28 comprising three sublayers : a bottom hardmask layer 28a, a middle hardmask layer 28b and a top hardmask layer 28c. A mask layer is defined within the present context as any layer configured to be patterned according to a given pattern whereafter the pattern is transferred to a layer lying underneath the mask layer. Transferring a pattern from a patterned mask layer to an underlying layer is defined within the present context as etching the underlying layer by an etch process that reproduces the mask pattern in the underlying layer. Said transferring includes embodiments wherein a tone reversal is performed before actually transferring the pattern, i.e. negative features (openings and trenches) are transformed to positive features (islands and lines) : for example if the mask layer is pattern of trenches, the trenches may be filled with a material followed by the removal of the mask material, so that positive lines remain. These lines are then transferred to the underlying layer.

The stack of hardmask layers 28a-28c is one possible embodiment of a 'mask layer' referred to in the appended claims. A mask layer may have other physical appearances within the wider scope of the invention. It may be a single layer, for example a layer of photoresist. The three-sublayer stack 28a-28c may be used to produce very small features, having dimensions in the order of nanometers. The invention is however not limited to any particular dimensions of the patterned features produced by the method of the invention.

The etch stop layer material 27 may depend on the hard mask stack material combination but can be a metal-based material (for example Ti, TiN, TiO₂, TiON, Ta, TaN...), an aluminium-based dielectric material, or a Si-based material like amorphous Si. The bottom hardmask layer material 28a depends on the hard mask stack material combination but can be a dielectric material used in semiconductor fabrication like Spin on glass, SiOC, SiO₂, SiN, SiON, SiCN, SiOCN, SiC, or a metal-based material (for example Ti, TiN, TiO₂, TiON, Ta, TaN...) or an aluminium-based dielectric material. The middle hardmask layer 28b can for example be an organic carbon-containing layer like amorphous carbon, Diamond like Carbon (DLC) or Spin on Carbon (SOC). The top hardmask layer 28c can be the same material as the bottom layer 28a or formed of one of the materials cited as possible materials for the bottom layer. The thickness of the top and bottom layers is preferably the same and smaller than the thickness of the middle layer. In the particular non-limiting embodiment illustrated in the drawings, the thickness of the top and bottom hardmask layers 28a,28c may be in the order of 10-15nm while the thickness of the middle layer 28b may be in the order of 50-100 nm.

On top of the mask layer 28, a resist layer 29 is formed and patterned by standard lithography according to a pattern of openings. The pattern is a regular array of circular openings 30 of equal diameter. In the case shown the pattern is a hexagonal pattern, i.e. each opening 30 is surrounded by six other openings at regular angular and linear distances from the central opening. The invention is however not limited to any particular pattern of openings, regular or irregular. By way of example, the openings may have a diameter of about 20 nm, with the center-to-center pitch of the array (distance between the centers of each pair of adjacent openings) about 46 nm.

The pattern of openings is transferred to the mask layer 28. This may be done by first etching the top mask layer 28c relative to the resist 29 using a first etch recipe. Then the middle hardmask layer 28b is etched using a second etch recipe that also etches the resist 29. The resist is therefore consumed as the openings are etched in the middle hardmask layer 28b. Then the bottom hardmask layer 28a is etched by a third etch recipe, while simultaneously the top hardmask layer 28c is consumed. The result is shown in Figure 5 : the pattern of openings 30 has been transferred to the bottom hardmask layer 28a and the middle hardmask layer 28b, i.e. openings 30 having upright sidewalls are formed through the layer 28a+28b. The term 'upright sidewalls' refers to sidewalls which are perpendicular to the plane of the support substrate 26 or close to perpendicular, i.e. a small deviation from the geometrical perpendicular orientation is included in the term 'upright'.

At this point, the hardmask layers 28a and 28b are subjected to a directional etch step as described above, and as illustrated in Figure 6. The directional etch beam 8 is scanned in the X-direction across the pattern of openings, thereby etching layers 28a and 28b selectively with respect to the etch stop layer 27.

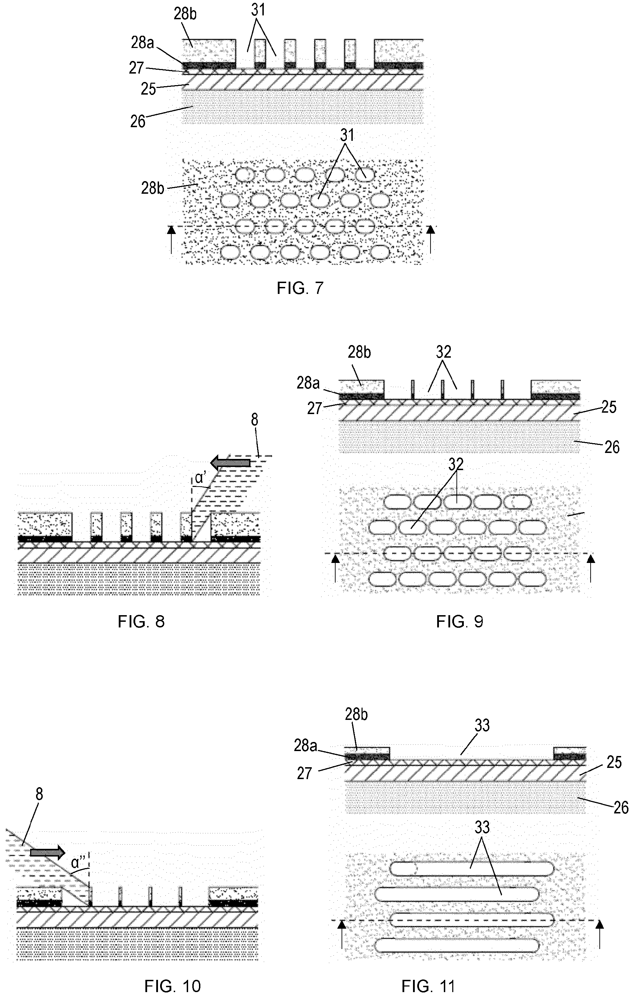

The angle of incidence α is such that the beam 8 impinges on the full height of the sidewall of the openings 30. After the passage of the beam, the openings 30 are enlarged as shown in Figure 7. The middle hardmask layer 28b has been thinned by the directional etch process, i.e. the original mask layer 28 is thinned : layer 28a and a thinned remaining portion of layer 28b are left after the passage of the directional etch beam 8. The directional etch process has elongated the openings 30 to form a pattern of line portions 31 formed as trenches in the thinned mask layer. A small degree of etching in the Y-direction is likely to take place due to a small etch rate in this direction, but this is not represented in the drawings.

A second directional etch step is then applied, this time by a plasma beam scanned in the opposite direction, as illustrated in Figure 8. The angle of incidence α' is higher than the angle of incidence α applied in the first directional etch step while still impinging on the full height of the sidewall of the elongated openings 31. The higher angle of incidence can be applied because of the thinning of the mask layer in the first directional etch step, i.e. the beam can be oriented closer to horizontal without the above-described negative impact of the shadow effect.

After the second etch step, the elongated openings are further elongated to form line portions 32 and the mask layer is further thinned, as illustrated in Figure 9. As the angle of incidence has increased, i.e. the beam is oriented closer to horizonal, the etch rate in the X-direction is higher, so that the elongation of the line portions is higher than in the first directional etch step.

With reference to Figure 10, a final directional etch step is then applied by scanning a plasma beam in a direction opposite to the scanning direction of the previous step. The angle of incidence α" is again higher than the angle α' applied in the previous step, as enabled by the further thinning of the mask layer.

As seen in Figure 11, the line portions 32 are again enlarged and now merge into a set of parallel line-shaped trenches 33 in the mask layer 28a+28b. The latter is further thinned but now at a lower etch rate compared to the previous directional etch steps.

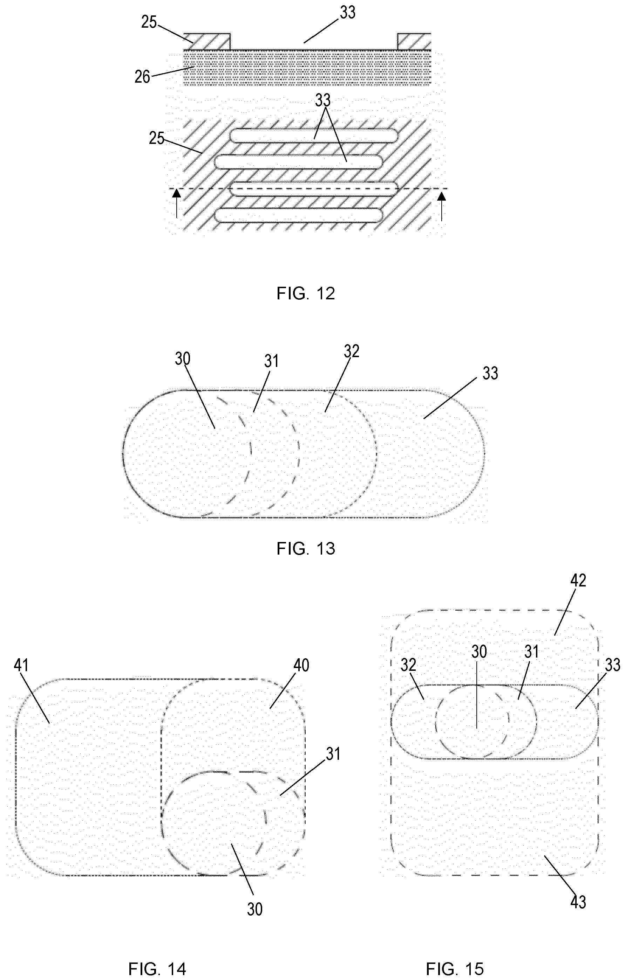

The final line pattern of line-shaped trenches 33 is then transferred to the etch stop layer 27 and to the target layer 25, as illustrated in Figure 12. Any remaining portions of the etch stop layer 27 and the mask layer 28 may be stripped after the pattern transfer to the target layer 25.

As is clear from the above description, the adjustment of the angle of incidence at each subsequent directional etching step increases the etch rate in the scanning direction progressively, which also increases the obtainable elongation while thinning of the patterned layer is progressively less as the beam is oriented more and more horizontally.

In the above-described embodiment, each subsequent directional etching step is performed by scanning in a direction that is diametrically opposed to the scanning direction in the previous step. In practice, using a tool as illustrated in Figure 1, this can be done by rotating the wafer stage 180° after a directional etch step and before the next directional etch step, performed at a higher angle of incidence. The angle of incidence can be adjusted for example by adjusting the position of the meniscus 9.

The above-described method steps are however applicable regardless of the directional etch technology that is being used. When applying a collimated beam that impinges on a full wafer, the beam is not scanned as indicated by the arrows in the Figures 6, 8 and 10, but the effect of the beam is the same. Changing the angle of incidence can be done by tilting the wafer. When applying a collimated beam of ionized gas clusters on a spot of the wafer, the beam may be scanned as illustrated in the drawings, while the angle adjustment is also done by tilting the wafer. The process sequence may be continued until a predefined elongation is obtained. Any realistically applicable number of directional etch steps can thus be applied. Due to the adjustment of the angle of incidence, the obtainable elongation is higher compared to a sequence wherein the same angle of incidence is applied at each directional etch step.

The invention is not limited to a process sequence wherein the consecutive directional etch steps are performed on a mask layer followed by the transfer of the mask pattern to a target layer. The consecutive etch steps could be performed directly on a target layer as well.

The invention is not limited to the above-described sequence wherein the scanning direction is reversed 180° at each directional etch step. It is also possible to apply the same scanning direction at each directional etch step, as illustrated schematically in Figure 13. The image shows three consecutive elongations 31 to 33, starting from a circular opening 30, elongated each time by scanning in same direction at progressively increasing angles of incidence.

It is also possible to apply scanning directions oriented at other angles than 0° or 180° relative to each other in the consecutive directional etch steps.

Figure 14 illustrates an embodiment wherein a circular opening 30 is first elongated to a line portion 31 in a first directional etch step, whereafter the line portion 31 is elongated to form a rectangular pattern feature 40 (with rounded corners) by scanning in a scanning direction oriented at 90° with respect to the previous step. In the last step, the scanning direction is again rotated 90° with respect to the previous step, and the angle of incidence is increased, resulting in an enlarged rectangular feature 41.

In the embodiment shown in Figure 15, the circular opening 30 is first enlarged by the sequence illustrated in Figures 4 to 12, i.e. each time scanning diametrically opposed to the previous step and progressivel increasing the angle of incidence, until reaching the line portion 33. This line portion is then enlarged in the direction oriented 90° to the previous scanning direction, to a rectangular portion 42, which is thereafter enlarged in the diametrically opposed direction and with a larger angle of incidence than the previous step, to a final rectangular portion 43.

As is clear to the skilled person, various other combinations of consecutive scanning directions and resulting pattern features can be applied within the scope of the invention.

In the embodiment illustrated in Figures 4 to 12, the angle of incidence is increased each time to the maximum angle that still impinges on the full height of the opening at the beginning of the directional etch step. This is the preferred approach, but the invention does not exclude applying an angle of incidence that is lower than this maximum, while still being higher than the angle applied in the preceding step. What counts is that the angle of incidence is increased at each step while impinging on the full height of the sidewall at the start of each step.

## Claims

1. A patterning method applicable in a semiconductor production process, comprising the steps of :
- producing an etch stop layer (27) on a support substrate (26,25),
- producing a layer (28) on the etch stop layer,
- patterning said layer thereby obtaining a patterned layer (28a,28b) comprising at least one opening (30) having upright sidewalls and extending through the full thickness of the patterned layer,
- in the patterned layer (28a,28b), elongating the at least one opening (30) by directional etching selectively relative to the etch stop layer, wherein said directional etching is performed according to a sequence of consecutive directional etching steps under the influence of a plasma beam (8) oriented according to an angle of incidence relative to the plane of the patterned layer (28a,28b) and scanned in a scanning direction relative to the opening, and wherein :
∘ the patterned layer (28a,28b) is thinned progressively under the influence of the consecutive directional etch steps,
∘ in each step, an angle of incidence (α,α',α") is applied that enables the beam to impinge on the full height of a sidewall of the opening at the start of the step,
∘ in each subsequent step, the angle of incidence is increased compared to the angle applied in the step immediately preceding said subsequent step,
∘ the sequence continues until a predefined elongation of the opening is obtained.

2. The method according to claim 1, wherein the scanning direction is changed at every subsequent step compared to the scanning direction applied in the step preceding said subsequent step.

3. The method according to claim 2, wherein the scanning direction of each subsequent step is diametrically opposed to the scanning direction of the preceding step, so that the pattern of geometrical features is a pattern of parallel lines.

4. The method according to claim 1, wherein the scanning direction of one or more subsequent directional etch steps is perpendicular to the scanning direction of the preceding step.

5. The method according to any one of the preceding claims, wherein the patterned layer (28a,28b) is patterned according to a pattern comprising a regular array of said openings (30) through the full thickness of the patterned layer, the array comprising rows of aligned openings, and wherein the directional etch steps are performed in scanning directions aligned to said rows, until the enlarged openings merge into a set of parallel lines (33).

6. The method according to any one of the preceding claims, wherein an etch stop layer (27) is produced on a target layer (25) present on the support substrate (26), wherein the layer produced in the etch stop layer (27) is a mask layer (28), and wherein the mask layer is patterned according to any one of the preceding claims, followed by transferring the pattern finally obtained in the mask layer to the target layer (25).

7. The method according to claim 6, wherein the mask layer (28) comprises a stack of sublayers, comprising from bottom to top :
- a first hardmask layer (28a) of a thickness t1,
- a second hardmask layer (28b) of a thickness higher than t1,
- a third hardmask layer (28c) of a thickness essentially equal to t1.
and wherein the third hardmask layer (28c) is consumed during the patterning of the mask layer to form said at least one opening (30) having upright sidewalls through the first and second hardmask layers (28a,28b).
